**Europäisches Patentamt**

**European Patent Office**

**Office européen des brevets**

(19)

(11) Publication number: **0 168 602**
**A1**

# EUROPEAN PATENT APPLICATION

(12)

(21) Application number: 85106493.1

(22) Date of filing: 25.05.85

(51) Int. Cl.⁴: **H 05 K 7/06**

(30) Priority: **25.06.84 US 624194**

(43) Date of publication of application: **22.01.86**
**Bulletin 86/4**

(84) Designated Contracting States: **AT CH DE IT LI NL SE**

(71) Applicant: **KOLLMORGEN TECHNOLOGIES CORPORATION, 66 Gatehouse Road, Stamford Connecticut 06902 (US)**

(72) Inventor: **Leon, Burke, 8 Tremont Court, Huntington, NY 11746 (US)**

(74) Representative: **Königseder, Claudia, Zugspitzstrasse 65, D-8104 Grainau (DE)**

(54) **Method for making interconnection circuit boards.**

(57) A heat-activatable polymer resin is applied as an overcoat to wire-scribed interconnection circuit boards after producing the wire-scribed conductor pattern in order to prevent drifting of the wire conductors during further processing of the boards.

EP 0 168 602 A1

222-124

# METHOD FOR MAKING INTERCONNECTION CIRCUIT BOARDS

This invention relates to a method for making wire-scribed circuit boards which are substantially free of wire-movement during manufacture and to wire-scribed circuit boards produced by the method of this invention.

The process for making wire-scribed circuit boards having discrete wire conductors adhesively attached to a suitable support is well known. A prefabricated base panel is coated with an adhesive layer and insulated conductors are applied by scribing them onto the panel in a predetermined pattern which connect selected points on the panel. Because the wire conductors are insulated, they can cross over one another as desired, thereby allowing the achievement of a high density conductor pattern. In one known version, the wires are bonded to the adhesive layer by simultaneous application of ultrasonic energy and pressure to the wire at or approximately at the point of contact between wire and adhesive during scribing. As a result, the wire conductors are pressed into and partially embedded in the adhesive layer. A protective epoxy resin-impregnated glass cloth (hereinafter referred to as the "prepreg") is then heat-/press-laminated onto the surface over the wire network. Other discrete wired circuit layers may be placed over the first circuit layer to form a more complex circuit having several layers. The lamination step is performed at temperatures of, e.g., approximately 175°C and pressures of approximately 2.4 MPa.

To bring the conductor terminations to the surface of the wire-scribed circuit boards, holes are drilled into the board at points where the wire conductors are to be connected so that the exposed ends of the conductors become part of the hole walls. The holes are then metallized. When holes are drilled through wire conductors not intended to serve as interconnect points, short circuits may result. Further, wire conductors which move from their assigned termination positions may not intersect or may only partly intersect the proper holes and thus may not form electrical connections or may be only partially connected, causing degradation in the quality of these connections. It has been observed that considerable wire conductor movement occurs during the lamination step. It is believed that this movement is caused by the instability of the materials lying beneath the wire conductors and, more specifically, the adhesive layer generally used in the production of wire-scribed circuit boards. This adhesive layer is typically made up of a layer of adhesive material, a layer of prepreg and another layer of adhesive. It is believed that the bonding between the layers is less than perfectly stable. Applicants have found that during lamination, the adhesive layer contacting the wire conductors tends to shrink causing wire movement. It is further believed that the pressing step of the laminating cycle also contributes to wire movement.

It has also been found that the conventional processing sequence sometimes allows the insulation of raised wires, particularly those in wire conductor cross-over areas, to become scratched during handling and subsequent processing, and damaged during lamination thus causing rejects.

While wire movement has been a problem for many years, its consequences have become increasingly significant as recent developments in electronic packaging necessitate increased wire conductor density, reduced wire and hole diameter and increased panel size.

One attempt to provide a solution to this problem is described in US patent 4,427,478. A photosensitive adhesive layer is laid down on the circuit panel into which the wiring is to be laid by the scribing process described hereinbefore. After forming the wire conductor pattern, the composite is exposed to ultraviolet radiation, which causes the photosensitive layer to crosslink and thus hold the wires in place. However, the crosslinking can only take place in the areas exposed to the path of the ultraviolet radiation. Because the wire conductor pattern partly shields the photosensitive layer from the ultraviolet radiation, areas shielded by the wire are not cured. Furthermore, wire conductors which occur in cross-over areas are not prevented from swimming since they are not adhered to the board.

US patent application Serial No. 254,132 describes a method for making specialized wire-scribed panels suitable for use with microelectronic chip carriers, which require completely planar surfaces for mounting. A thick, planar layer of thermosetting resin is applied over wire-scribed panels and allowed to level and set at room temperature or at a temperature less than 100°C in order to form a planar surface. The planar surface is then used to mount microelectronic components contained in leadless ceramic chip carriers.

This process is not only difficult to perform and expensive, but at the same time not suitable for laminating to the surface a resin impreganted glass cloth or similar topsheet.

Therefore, it is an object of this invention to provide a reliable process for making wire-scribed circuit boards without allowing the wire conductors to migrate during adhesive curing, lamination process steps and further processing.

It is a further object of this invention to provide a process of making wire-scribed circuit boards wherein the wires are substantially stationary during the lamination process.

It is still a further object of this invention to provide a means for protecting wires from being damaged by physical handling during processing.

It is yet another object of this invention to provide an economical process for preventing wire migration in wire-scribed circuit boards.

A method of making wire-scribed circuit boards has been found which, unexpectedly, substantially prevents wire migration of discrete insulated wire conductors in an economical and efficient manner.

This method comprises the steps of (a) coating a prefabricated planar base panel with an adhesive layer; (b) scribing insulated wire conductors onto the base panel thus adhering said wires to the adhesive coating in a predetermined pattern and is characterized in that it further comprises the steps of (c) drying the panel at a temperature insufficient to cause the wires to move; (d) applying a heat activatable overcoat material over the surface of the panel so as to encapsulate the exposed areas of the adhesive layer and the exposed surfaces of the insulated conductors, said overcoat material not substantially changing in dimension during curing; and (e) exposing the overcoat material to UV energy or heat sufficient to cause the overcoat material to become rigid and prevent the movement of the wire conductors during subsequent processing, but insufficient to cause movement of the wires attached to said adhesive coating.

The overcoat layer (hereinafter also referred to as the "overcoat") should be a thermoset material which does not move or destabilize under further exposure to process steps employing heat and/or pressure. The overcoat effectively restrains wire motion during subsequent lamination or other process steps. Applied immediately after scribing the conductor network, this coating also prevents damage to the wire conductors caused by handling. The overcoat forms a hard layer which resists scratching. This method inexpensively and effectively solves the wire migration problem. It is surprisingly easy to perform and can be added to a conventional manufacturing process without excess equipment or extraordinary expense. It is not time-consuming and can be performed efficiently. No special training is required to use the method of this invention.

In order to be suitable for use in the method of this invention, the overcoat material must be capable of effectively wetting or encapsulating the surfaces with which the overcoat layer interfaces, e.g., insulated wire conductors provided or not with an adhesive coating, the exposed areas of the adhesive layer, or other exposed surfaces provided with the scribed wire conductors and, if applied, any subsequent layer placed on top of it, such as a resin impregnated glass cloth (prepreg) layer. It is desirable that the overcoat layer, in its liquid state, wick down between the wire conductors at cross-over points of said conductors and encapsulate them around their perimeters to the fullest extent possible.

The necessary properties of the coating material are:
- it should be free of substantial dimensional changes during curing, at least in the longitudinal direction;
- it should cure at temperatures and exposure times which do not substantially soften or degrade the adhesive layer;
- it should securely adhere to the surface of the adhesive layer and/or wire conductor surface; and
- in its fully or partially cured stage it must be suitable for secure attachment of a subsequent layer.

The coating material is preferably a non-conductor; conductive materials may, however, be used.

The overcoat preferably comprises a cross-linking polymer such as an epoxy, an acrylic, a polyimide and the like. If an epoxy base is chosen, the overcoat preferably further comprises a hardener, preferably a composition comprising diamine, a tertiary amine and a rubber. More preferably, when an epoxy base is chosen, the hardener should contain an aromatic diamine, a tri-dimethylaminophenol and carboxy-terminated butylnitrile (CTBN) rubber. It should, preferably, contain a levelling agent. The levelling agent may be a bubble-breaking agent and/or a degassing agent. Preferably, the levelling agent should be a fumed silica of fine particle size when the composition is epoxy-based.

The overcoat composition preferably contains an epoxy resin, an acrylic polymer liquid, a catalyst for electroless plating, fumed silica, and an amine hardener. More preferably, the overcoat composition contains a phenolic novolac epoxy, a high-viscous acrylic polymer, a palladium catalyst containing epoxy resin and dimethyl formamide, fumed silica and hardener having aromatic diamines, rubber and a small amout of tri-dimethylaminophenol. Another preferred overcoat composition contains 30% by weight of a bis-phenol A epoxy acrylate resin, 12% by weight of a phenoxy-ethyl-acrylate, 12% of a butyleneglycoldimethacrylate, 40% of fine-grained talc and hydrated alumina, and trace amounts of fine-grained fumed silica, polyethylene, benzoic ether, dimethyaminopropylmethacryloamide  and a levelling agent. This composition may be cured by exposure to UV radiation.

A preferred overcoat composition, which is thermally curable, may contain a solid epoxy-novolac resin with a functionality of between 4 and 5, diethyleneglycol ethyl ether, an epoxy-novolac resin, alumina and small amounts of fumed silica, and levelling agent with a hardener containing a high percentage of an aromatic diamine, and small amounts of carboxy-terminated butadiene rubber and epoxy resin. Another preferred overcoat composition may be made using a high percentage of a polyimide resin monomer and small amounts of fumed silica and mineral oils as a levelling agent.

The overcoat composition may also contain one or more solvents to adjust viscosity. The extent to which the solvent components are needed depends upon the method of applying the overcoat.

The base panel may be composed of thermoplastic or thermosetting resinous material or ceramic material, or of a metal, preferably provided with a non-conductive top layer. The panel is coated with an adhesive layer of a composition known to those skilled in the art. Preferably, if the overcoat has an epoxy base, the adhesive layer should be an epoxy-based composition.

Conductors are then applied, or scribed , onto the base in a predetermined pattern. The conductors comprise a metal core and an  insulating layer and may be coated with a conductive or non-conductive coating.

The overcoat composition of this invention is preferably applied by screen printing techniques, thus providing a thin uniform layer of overcoat material. The overcoat composition of this invention is preferably slightly thixotropic upon application.

Application of the overcoat may be accomplished by other means known in the art.

Dip-coating is one such other method of application: the base panel provided with the wire conductor network is immersed in a relatively free-flowing composition of the overcoat material thus depositing a thin layer of overcoat material.

Another preferred method is curtain coating; doctor blading and roller coating may also be used.

The thickness of the applied layer of energy activatable overcoat can have a relatively wide range. It was found that a thinner coat unexpectedly locks the wires into position as well as a thicker coat would. Thickness of the resulting dry film overcoat can range from about 12.5 $\mu$m to about 125 $\mu$m. Thinner coats incur less cost and are easier to apply.

After applying the layer of thermosetting material, the panel is preferably allowed to stand for 5 to 10 minutes at room temperature to allow bubbles to vent. Curing conditions, e.g., temperature, exposure time, etc., depend upon the composition of the overcoat material and the method of application. The following data are not fixed parameters, but are typically suitable for certain compositions, such as those described in the Example  below. The panel provided with the overcoat is placed for partial curing in an oven set at a temperature from 40°C to 70°C for 5 minutes to thoroughly wet the surface and to break any more bubbles which have formed. This also allows the overcoat to lose its thixotropic qualities and temporarily sag and level. The panel is then baked at 110°C to 130°C for 10 to 20 minutes in order to allow further partial curing to occur. Both, the bubble breakers present in the composition and the delay in a low-temperature oven contribute to degassing the overcoat material. The panel can then be baked at a later time for about 30 minutes at 165°C to allow the adhesive to cure fully, or the adhesive may be cured as part of a subsequent processing step.

The panel is then able to be processed further substantially free of wire conductor movement. A prepreg layer of resin impregnated glass cloth or the like may be laminated to the surface. Optionally, the panel may be baked after lamination, e.g., for 1 hour at 175°C to permit the prepreg to fully cure.

If a prepreg layer is not to be applied, the overcoat layer is fully cured prior to subjecting the panel to further processing.

The following Example illustrates the advantages of the process of this invention.

### EXAMPLE

A two-ounce copper clad panel was printed and etched to form the desired power and ground conductor pattern (hereinafter referred to as "format"). The copper surface of the format board was treated to form a black oxide layer and then dip-coated with resin, dried for an hour and baked. The surface was abraded by brushing and a composition containing ethylene glycol butylether, epoxy resin, an acrylic levelling agent, a palladium catalyst composition, an aqueous surfactant, fumed silica, a hardening agent containing an aromatic diamine, carboxy-terminated butylnitrile (CTBN) rubber and tri-dimethylaminophenol was applied by screen printing. The panel was baked. A similar composition containing butyl cellosolve, epoxy resin, an acrylic levelling agent, a palladium catalyst, an aqueous surfactant, fumed silica and CTBN rubber was then screen printed onto the panel and the panel was baked. The surface was abraded by brushing.

An adhesive was then applied to the surface of the panel
consisting of a 0,025 mm layer of adhesive film containing acrylonitrile butadiene copolymer, 20,8 % alkylphenol
resin, Epon 1001®, chloro-sulfonated polyethylene, thermoset epoxy novolac phenolic resin, and trace amounts of
zirconium silicate, palladium catalyst, fumed silica,
acrylic polymer, pigment and sellosolve acetate; a layer
of glass cloth; and a 0,05 mm layer of adhesive.

The panel was then exposed to a laminating step for 6
minutes at 120°C and 5.7 MPa of pressure and cooled at
said pressure for 6 minutes.

Subsequently, wire conductors were scribed onto the panel in a
test grid pattern with conductors arranged laterally and
longitudinally across the panel. The wired panel was flush-
pressed for 20 minutes at 6.4 MPa and 120°C to partially
embed the wires in the adhesive layer and baked at 175°C
for 30 minutes.

Wire movement was measured at ten positions on the test
grid pattern.

An overcoat material containing 14.5 % butyl cellosolve,
77 % DEN 438®, (a phenol novolac epoxy having an epoxy
equivalent weight of 176-181), 2.0 % modaflow® levelling
agent, (an acrylic polymer), 1.0 % PEC8 palladium catalyst
(containing 14.6 % dimethyl formamide, 83.7 % Epon 828® ,
a bis-phenol A epoxy resin and 1.7 % palladium chloride),
0,2 % Level® (fumed silica levelling agent of fine particle size) and 8.0 % CTBN rubber, was applied to
wire-scribed panels made according to the process described
above up to an excluding the laminating procedure.

The scribed wire conductors and the exposed surfaces of
the adhesive were provided with the overcoat layer by
screen printing through a 60-mesh screen. The panels were
held stationary at room temperature for 5 minutes, subsequently baked at 65°C for 5 to 10 minutes  and then at
120°C for 20 minutes. These panels were further baked at 165°C for 30 minutes to allow the adhesive to set.
Two sheets of prepreg were applied and the entire assembly
press-laminated at 120°C and 8.5 MPa for 20 minutes. The
entire assembly was then baked for 1 hour at 165°C.
Measurements of wire migration after lamination were made.
The resulting wire movement for a typical board without
overcoat are shown in Table I and the respective result
for 5 boards A to E provided with the overcoat of this
invention in Table II.

## TABLE I

### Wire Movement Without Overcoat

| Position Measured after | Flush Press | Wire Movement (mm)* After Prepreg | Total |
|---|---|---|---|
| 1 | 1.00 | 0 | 1.00 |
| 2 | 0 | 0.50 | 0.50 |
| 3 | 0.75 | 0 | 0.75 |
| 4 | 0 | 0 | 0 |
| 5 | 0 | 1.75 | 1.75 |
| 6 | 0.75 | 1.00 | 1.75 |
| 7 | 2.25 | 0 | 2.75 |
| 8 | 1.75 | 0.75 | 2.50 |
| 9 | 0 | 0 | 0 |
| 10 | 1.75 | 1.00 | 2.75 |

*all data ± 0.50 mm

## TABLE II

### Wire Movement With Overcoat

| Position Measured Panel: | Total Wire Movement (mm) | | | | |
|---|---|---|---|---|---|
| | A | B | C | D | E |
| 1 | 0* | 0 | 0 | 0.50 | 0 |
| 2 | 0 | 0 | 0 | 0 | 0 |
| 3 | 0 | 1.00 | 0 | 0 | 0 |
| 4 | 0.50 | 1.00 | 0.50 | 0 | 0 |
| 5 | 0 | 0 | 0 | 0 | 0 |
| 6 | 0.50 | 0 | 0 | 0 | 0 |
| 7 | 1.25 | 0.75 | 0 | 1.00 | 0 |
| 8 | 1.00 | 0 | 0 | 0 | 0.50 |
| 9 | 0 | 0.75 | 0 | 0 | 0 |
| 10 | 0.50 | 1.00 | 0 | 0 | 0.50 |

*all data ± 0.50 mm

0168602

CLAIMS:

1.      A method for making a wire-scribed circuit board, said method comprising the steps of

(a) coating a prefabricated planar base panel with an adhesive layer;

(b) scribing insulated wire conductors onto the base panel thus adhering said wires to the adhesive coating in a predetermined pattern;

c h a r a c t e r i z e d  in that it further comprises the steps of

(c) drying the panel at a temperature insufficient to cause the wires to move;

(d) applying a heat activatable overcoat material over the surface of the panel so as to encapsulate the exposed areas of the adhesive layer and the exposed surfaces of the insulated conductors, said overcoat material not substantially changing in dimension during curing; and

(e) exposing the overcoat material to UV energy or heat sufficient to cause the overcoat material to become rigid and prevent the movement of the wire conductors during subsequent processing, but insufficient to cause movement of the wires attached to said adhesive coating.

2.      The method of claim 1 wherein said overcoat material is initially heated at a temperature between 40° and 70° C, then baked at a temperature between 110° and 139°C for     10   to 20 minutes, and then baked further at a temperature of 165°C for       30 minutes.

3.      The method of claim 1 further includung the steps of applying a polymer-impregnated glass cloth layer over the partially cured overcoat material and laminating said cloth layer.

4.      The method of claim 1 wherein said overcoat material comprises a cross-linking polymer, a hardener and a levelling agent.

5.      The method of claim 4 wherein said cross-linking polymer is an epoxy, an acrylic, a polyimide, or a combination thereof.

6.      The method of claim 4 wherein said hardener comprises a diamine, a tertiary amine and a carboxy-butylnitrile rubber.

7.      The method of claim 4 wherein said levelling agent comprises fumed silica of fine particle size.

8.      A wire scribed interconnection circuit board made according to the method of claims 1 to 7.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | GB-A-2 099 225 (AUGAT) <br> * Figures 3,6-9; claims 15-22 * | 1,3 | H 05 K 7/06 |
| A,D | EP-A-0 097 817 (IBM) <br> * Claim 1 * | 1 | |

TECHNICAL FIELDS SEARCHED (Int. Cl.4)

H 05 K

The present search report has been drawn up for all claims

| Place of search | Date of completion of the search | Examiner |
|---|---|---|
| THE HAGUE | 02-10-1985 | TOUSSAINT F.M.A. |